# EUROPÄISCHE PATENTSCHRIFT

(11) **EP 2 880 194 B1**
(45) Veröffentlichungstag und Bekanntmachung des Hinweises auf die Patenterteilung: **06.03.2019**
(21) Anmeldenummer: 13742425.5
(22) Anmeldetag: 23.07.2013
(51) Int. Cl.: C23C 14/00, C23C 14/08, C23C 14/16, C23C 14/18, C23C 14/34, C23C 14/35, C23C 14/58, C23C 28/00, C23C 28/04, C23C 30/00, C25D 11/04, C25D 11/26, C25D 11/32

(54) **SCHNEIDWERKZEUG MIT VERSCHLEISSERKENNUNGSSCHICHT**
CUTTING TOOL WITH WEAR-RECOGNITION LAYER
OUTIL DE COUPE DOTÉ D'UNE COUCHE TÉMOIN D'USURE

(30) Priorität: 03.08.2012 DE 102012107130
(43) Veröffentlichungstag der Anmeldung: 10.06.2015
(73) Patentinhaber: Walter AG, 72072 Tübingen (DE)
(72) Erfinder: HAMPSCH, Sebastian, 73760 Ostfildern (DE); SCHIER, Veit, 70771 Leinfelden-Echterdingen (DE)
(74) Vertreter: WSL Patentanwälte Partnerschaft mbB
(86) Internationale Anmeldenummer: PCT/EP2013/065547
(87) Internationale Veröffentlichungsnummer: WO 2014/019896

(56) Entgegenhaltungen:
- WO-A1-2004/087994
- WO-A1-2011/085796
- WO-A1-2013/037967
- DE-A1- 10 118 763

## Beschreibung

### Gegenstand der Erfindung

Die vorliegende Erfindung betrifft ein Werkzeug, bestehend aus einem Substratkörper aus Hartmetall, Cermet, Keramik, Stahl oder Schnellarbeitsstahl, einer optional auf dem Substratkörper abgeschiedenen ein- oder mehrlagigen Verschleißschutzbeschichtung und einer als äußerste Schicht über dem Substratkörper oder der Verschleißschutzbeschichtung angeordneten Verschleißerkennungsschicht, sowie ein Verfahren zur Herstellung des Werkzeugs.

### Hintergrund der Erfindung

Schneidwerkzeuge, insbesondere solche für die spanende Metallbearbeitung, zu denen auch Wechselschneideinsätze und Schneidplatten zählen, umfassen ein Substrat oder einen Grundkörper mit einer optional darauf abgeschiedenen ein- oder mehrlagigen Verschleißschutzbeschichtung. Das Substrat besteht üblicherweise aus Hartmetall, Cermet, Keramik, Stahl oder Schnellarbeitsstahl und die Verschleißschutzbeschichtung aus Hartstoffen, die im CVD-Verfahren oder PVD-Verfahren aufgebracht werden. Die Beschichtung mit Hartstoffen soll die Schneideigenschaften des Werkzeugs für eine bestimmte Anwendung verbessern und den Verschleiß des Werkzeugs verringern.

Es ist weiterhin bekannt, die Schneidwerkzeuge mit einer zumeist dünnen äußersten Lage mit einer Dekor- und/oder Indikatorfunktion zu versehen, beispielsweise eine äußerste Lage aus TiN, ZrN, TiC, HfC oder HfN, die sich zweckmäßigerweise farblich von der darunter angeordneten Verschleißschutzschicht unterscheidet. Solche Lagen können neben rein dekorativem Zweck mit Vorteil auch der Verschleißerkennung dienen, da sie sich beim Gebrauch des Werkzeugs abnutzen und die darunter angeordnete Lage sichtbar wird, wodurch sich bereits mit bloßen Auge erkennen lässt, ob und wie intensiv ein Werkzeug bereits benutzt wurde.

Die EP 1 762 638 beschreibt einen Schneideinsatz aus einem Hartmetallsubstrat und einer mehrlagigen Hartstoffbeschichtung für den Verschleißschutz sowie einer äußersten Indikatorlage aus ZrN, die zunächst in einer Dicke von <1 µm mittels PVD aufgetragen wird und dann von der Spanfläche und der Schneidkante durch Bürsten oder Strahlbehandlung wieder entfernt wird, da die Lage aus ZrN als solche ungünstige tribologische Eigenschaften besitzt, die die Schneideigenschaften an der Schneidkante und der Spanfläche nachteilig beeinflussen können.

Die DE 10 2004 010 285 und die DE 100 48 899 beschreiben ebenfalls Schneidwerkzeuge mit einer Indikatordeckschicht aus goldgelbem TiN oder auch aus TiC, HfC oder HfN, die sich farblich von der darunter angeordneten Verschleißschutzschicht unterscheiden und es ermöglichen sollen, ein benutztes Schneidwerkzeug von einem unbenutzten mit dem bloßen Auge zu unterscheiden.

Die WO 2004/087994 beschreibt die Herstellung von dekorativen und/oder schützenden Metalloxidbeschichtungen auf Substraten mittels PVD-Beschichtungstechniken. Die durch anodische Oxidation hergestellte Metalloxidlage verleiht dem beschichteten Substrat durch Interferenz Farbe. Solche an sich bekannten Interferenzmetalloxid-Lagen können Poren aufweisen, welche am Substrat eine Stromsenke verursachen. Zur Lösung dieses Problems wird das Vorsehen einer Barriereschicht zwischen Substrat und Interferenzmetalloxid-Schicht vorgeschlagen, welche aus einem anodisch oxidierbaren Material besteht. Bei der Durchführung von anodischer Oxidation der Interferenzmetalloxid-Schicht soll dort, wo in dieser Schicht Poren vorhanden sind, die Barriereschicht lokal anodisch oxidiert werden und verhindern, dass am Substrat die nachteilige Stromsenke entsteht.

Die WO 2011/085796 beschreibt ein Werkzeug, das mit einer einlagigen farbgebenden Beschichtung versehen wird, wobei im PVD-Verfahren eine Metallschicht auf ein Werkzeugsubstrat aufgebracht und diese Metallschicht in einem weiteren Verfahrensschritt anodisch oxidiert wird.

Die Farbvariationsbreite der bekannten Deckschichten mit Dekor- und/oder Indikatorfunktion, welche nachfolgend als Verschleißerkennungsschichten bezeichnet werden, ist äußerst begrenzt. Die sehr häufig für Verschleißerkennungsschichten eingesetzten Nitride und Carbide haben beispielsweise eine goldgelbe Farbe. Darüber hinaus haben einige der bekannten Verschleißerkennungsschichten nachteilige tribologische Eigenschaften, die sich ungünstig auf den Zerspanprozess und das Verschleißverhalten der Werkzeuge auswirken. Einige der bekannten für die Herstellung von Verschleißerkennungsschichten eingesetzten Materialien sind zudem unter den bei vielen Metallbearbeitungsverfahren auftretenden hohen Temperaturen oder Temperaturwechseln nicht ausreichend stabil.

### Aufgabe

Der Erfindung lag daher die Aufgabe zugrunde, eine Beschichtung für Schneidwerkzeuge bereitzustellen mit einer Dekor- und/oder Indikatorfunktion (Verschleißerkennungsschicht), die vergleichsweise einfach und kostengünstig herzustellen ist, eine gute Verschleißerkennbarkeit erlaubt, temperaturstabil ist, weniger tribologisch ungünstige Einflüsse auf den Zerspanprozess und das Verschleißverhalten des Werkzeugs hat und gleichzeitig in einer breiteren Farbenvielfalt als bekannte Verschleißerkennungsbeschichtungen herstellbar ist.

### Beschreibung der Erfindung

Erfindungsgemäß wird diese Aufgabe gelöst durch ein Werkzeug, bestehend aus
einem Substratkörper aus Hartmetall, Cermet, Keramik, Stahl oder Schnellarbeitsstahl,
einer optional auf dem Substratkörper abgeschiedenen ein- oder mehrlagigen Verschleißschutzbeschichtung und
einer als äußerste Schicht über dem Substratkörper oder der optionalen Verschleißschutzbeschichtung angeordneten, wenigstens 4 übereinander angeordnete Einzellagen umfassenden mehrlagigen Verschleißerkennungsschicht (B), hergestellt durch Abscheidung von elementaren Metallen, Metalllegierungen oder elektrisch leitfähigen Metallverbindungen im PVD-Verfahren, wobei
wenigstens eine Einzellage der mehrlagigen Verschleißerkennungsschicht (B) wenigstens zwei verschiedene Metalle enthält,
die Verschleißerkennungsschicht einen durch anodische Oxidation des Materials der Verschleißerkennungsschicht von der äußeren Oberfläche der Verschleißerkennungsschicht bis zu einer Eindringtiefe, welche sich nicht über die gesamte Dicke der Verschleißerkennungsschicht erstreckt, hergestellten Bereich umfasst,
jede Einzellage der mehrlagigen Verschleißerkennungsschicht (B) eine Dicke im Bereich von 10 nm bis 1 µm aufweist und
die wenigstens eine wenigstens zwei verschiedene Metalle enthaltende Einzellage der mehrlagigen Verschleißerkennungsschicht (B) vor der anodischen Oxidation und in den nicht anodisch oxidierten Bereichen der Verschleißerkennungsschicht wenigstens zwei verschiedene Phasen aufweist.

Es wird unterschieden zwischen Ausführungsformen mit einer einlagigen Verschleißerkennungsschicht (A), die auch als Monolayer-Struktur bezeichnet wird, und erfindungsgemäßen Ausführungsformen mit einer mehrlagigen Verschleißerkennungsschicht (B), die auch als Multilayer-Struktur bezeichnet wird.

Eine einlagige Verschleißerkennungsschicht (A) umfasst nur eine Einzellage, die jedoch aufgrund der nach der PVD-Abscheidung der Lage durchgeführten anodischen Oxidation einen sich von der äußeren Oberfläche der Verschleißerkennungsschicht bis in die Lage hinein erstreckenden Bereich umfasst, in dem das Material der Lage in oxidiertem Zustand vorliegt, und einen sich von dem oxidierten Bereich bis zu der Oberfläche des Substratkörpers oder der Verschleißschutzbeschichtung erstreckenden Bereich umfasst, in dem das Material der Lage in dem nicht oxidierten Zustand vorliegt.

Die erfindungsgemäße mehrlagige Verschleißerkennungsschicht (B) umfasst wenigstens vier Einzellagen und kann vorzugsweise bis zu 2000 Einzellagen umfassen, wobei die Verschleißerkennungsschicht (B) aufgrund der nach der PVD-Abscheidung durchgeführten anodischen Oxidation einen sich von der äußeren Oberfläche der äußersten Einzellage bis in die mehrlagige Verschleißerkennungsschicht (B) hinein erstreckenden Bereich umfasst, in dem das Material in oxidiertem Zustand vorliegt, und einen sich von dem oxidierten Bereich bis zu der Oberfläche des Substratkörpers oder der Verschleißschutzbeschichtung erstreckenden Bereich umfasst, in dem das Material der Lage in dem nicht oxidierten Zustand vorliegt. Die Eindringtiefe der anodischen Oxidation kann sich über mehrere Einzellagen erstrecken. Alternativ kann auch nur die äußerste Einzellage der mehrlagigen Verschleißerkennungsschicht (B) anodisch oxidiert sein. Bevorzugt endet die anodische Oxidation an der Grenzfläche zwischen zwei Einzellagen innerhalb der mehrlagigen Verschleißerkennungsschicht (B).

Die erfindungsgemäße Verschleißerkennungsschicht weist wesentliche Vorteile auf gegenüber bekannten Dekor- und Indikatorschichten, wie beispielsweise TiN, welches wegen seiner hohen Affinität zu beispielsweise Gusseisen Nachteile als Beschichtung für Werkzeuge zur Bearbeitung solcher Werkstoffe hat. Die erfindungsgemäße Verschleißerkennungsschicht besitzt an ihrer Oberfläche oxidische Eigenschaften, was gegenüber bekannten Nitrid- oder Carbidschichten unter tribologischen Gesichtspunkten wesentliche Vorteile haben kann. So werden durch diese tribologisch vorteilhaften Eigenschaften ungünstige Einflüsse auf die Zerspanungseigenschaften und das Verschleißverhalten des Werkzeugs verringert.

Je nach den eingesetzten Metallen oder den eingesetzten elektrisch leitfähigen Metallverbindungen sowie dem Ausmaß der anodischen Oxidation und der Schichtdicke, sind die erfindungsgemäßen Verschleißerkennungsschichten gut bis hochgradig temperaturstabil, weshalb sie sich für Werkzeuge für die spanende Metallbearbeitung, bei der häufig sehr hohe Temperaturen oder auch Temperaturwechselbelastungen auftreten, besonders gut eignen.

Ein weiterer Vorteil der erfindungsgemäßen Verschleißerkennungsschichten besteht darin, dass in Abhängigkeit von den verwendeten Metallen oder den verwendeten elektrisch leitfähigen Metallverbindungen und dem Ausmaß und der Eindringtiefe der anodischen Oxidation ein sehr intensiver Farbeffekt, eine sehr große Vielzahl unterschiedlicher Farben und Helligkeiten, die nahezu das gesamte sichtbare Farbspektrum abdecken, hergestellt werden kann. Auf diese Weise können nicht nur der Verschleißerkennung dienende äußere Oberflächenschichten hergestellt werden, vielmehr können Werkzeuge auch durch unterschiedliche Farbgebung gekennzeichnet werden, sodass der Benutzer verschiedene Werkzeugsorten bzw. Werkzeugtypen bereits anhand der Farbe unterscheiden kann. Die erfindungsgemäße Verschleißerkennungsschicht kann somit ausschließlich eine Verschleißerkennungsfunktion haben oder neben der Verschleißerkennungsfunktion auch einer Farbkodierung von Werkzeugen dienen. Im Vergleich zu bekannten Verschleißerkennungsschichten können die erfindungsgemäßen Verschleißerkennungsschichten eine deutlich höhere Brillianz der Farbgebung aufweisen. Die für die anodische Oxidation bei der Herstellung der erfindungsgemäßen Verschleißerkennungsschichten erforderlichen Spannungen können variieren.

Ohne dass sich die Erfinder hiermit an eine Theorie binden lassen, gehen sie davon aus, dass der Farbeffekt der erfindungsgemäßen Verschleißerkennungsschicht auf der Reflexion von Licht beruht, das durch den durch anodische Oxidation hergestellten äußeren Bereich der Verschleißerkennungsschicht auf den nicht oxidierten inneren Bereich der Verschleißerkennungsschicht auftrifft. Interferenzeffekte liefern die zu beobachtenden Farben. In besonderen Fällen kann der Farbeffekt aber auch auf der Eigenfarbe des anodisch oxidierten äußeren Bereichs der Verschleißerkennungsschicht beruhen.

Ein wesentliches Merkmal der vorliegenden Erfindung ist, dass die wenigstens eine wenigstens zwei verschiedene Metalle enthaltende Einzellage der mehrlagigen Verschleißerkennungsschicht (B) vor der anodischen Oxidation und in den nicht anodisch oxidierten Bereichen der Verschleißerkennungsschicht wenigstens zwei verschiedene Phasen aufweist. Es wurde überraschen festgestellt, dass aufgrund des Vorhandenseins von wenigstens zwei verschiedenen Phasen in wenigstens einer Einzellage der Verschleißerkennungsschicht andere Farbtöne hergestellt werden können als in bekannten oder vergleichbaren Beschichtungen, in denen die Einzellagen nicht wenigstens zwei verschiedenen Phasen in wenigstens einer Einzellage aufweisen.

Der Begriff "Phase" innerhalb einer mehrphasigen Lage der Verschleißerkennungsschicht bezeichnet im Sinne der vorliegenden Erfindung bezeichnet Bereiche gleicher Kristallstruktur und chemischer Zusammensetzung. Zwei verschiedene Phasen im Sinne der vorliegenden Erfindung weisen entweder gleiche Kristallstruktur und unterschiedliche chemische Zusammensetzung, unterschiedliche Kristallstruktur und gleiche chemische Zusammensetzung oder unterschiedliche Kristallstruktur und unterschiedliche chemische Zusammensetzung auf.

Die Mehrphasigkeit der Einzellage einer einlagigen Verschleißerkennungsschicht (A) vor der anodischen Oxidation und in den nicht anodisch oxidierten Bereichen lässt sich erfindungsgemäß im Röntgenbeugungsspektrum nachweisen. Dem Fachmann ist die Methode geläufig und er erkennt am Spektrum ohne weiteres, ob eine einphasige oder eine zwei- oder mehrphasige Lage vorliegt. In einer erfindungsgemäßen, wenigstens vier übereinander angeordnete Einzellagen umfassenden mehrlagigen Verschleißerkennungsschicht (B) ist die Zuordnung mehrerer verschiedener Phasen zu exakt einer Lage der mehrlagigen Verschleißerkennungsschicht im Röntgenbeugungsspektrum nicht ohne weiteres eindeutig möglich, da das Verfahren integral über mehrere Lagen hinweg misst. Die Mehrphasigkeit innerhalb einer Einzellage, welche wenigstens zwei verschiedene Metalle enthält, lässt sich jedoch mittels Elektronenbeugung (ED) an einer querschnittspräparierten Probe durch Transmissionselektronenmikroskopie (TEM) nachweisen. Selbstverständlich eignet sich dieses Verfahren auch zum Nachweis der Mehrphasigkeit der Einzellage einer einlagigen Verschleißerkennungsschicht (A).

Ist die Verschleißerkennungsschicht einlagig, d. h. sie besteht aus einer durch Abscheidung von wenigstens zwei verschiedenen Metallen in elementarer Form, in der Form von Metalllegierung oder in der Form elektrisch leitfähiger Metallverbindungen im PVD-Verfahren hergestellten Einzellage. Die Einzellage weist eine Dicke im Bereich von 100 nm bis 10 µm und wenigstens zwei verschiedene Phasen auf. Enthält die Einzellage beispielsweise zwei verschiedene Metalle M1 und M1, können die verschiedenen Phasen eine erste metallische Phase des Metalls M1, eine zweite metallische Phase des Metalls M2 und eine intermetallische Phase der Metalle M1 und M2 sein. Die verschiedenen Phasen sind im Röntgenbeugungsspektrum nachweisbar. Es wurde überraschend gefunden, dass bei einer einlagigen Verschleißerkennungsschicht, bestehend aus einer Einzellage mit wenigstens zwei verschiedenen Metallen und wenigstens zwei verschiedenen Phasen innerhalb der Einzellage, brilliantere und klarere Farben erzielt werden können als mit einer nur ein einziges Metall enthaltenden Einzellage.

Bei der vorliegenden Erfindung ist die Verschleißerkennungsschicht mehrlagig, d. h. sie besteht aus wenigstens 4 übereinander angeordneten, im PVD-Verfahren abgeschiedenen Einzellagen. Jede Einzellage enthält entweder ein Metall oder mehrere verschiedene Metalle, wobei Metalle in elementarer Form, in der Form von Metalllegierung oder als elektrisch leitfähige Metallverbindungen abgeschieden sein können. Jede Einzellage der mehrlagigen Verschleißerkennungsschicht weist eine Dicke im Bereich von 10 nm bis 1 µm auf. Wenigstens eine Einzellage der mehrlagigen Verschleißerkennungsschicht weist wenigstens zwei verschiedene Phasen auf.

Nach der PVD-Abscheidung wird die Verschleißerkennungsschicht einer anodischen Oxidation unterzogen. Bei der anodischen Oxidation wird das beschichtete Werkzeug in einem Elektrolytbad als Anode geschaltet. Die Oxidation erfolgt bei einer vorgegebenen Spannung, die beispielsweise im Bereich von 20 bis 150 V aber auch außerhalb dieses Bereichs liegen kann, für einen ausgewählten Zeitraum, der im Bereich von 10 bis 300 Sekunden aber auch außerhalb dieses Bereichs liegen kann. Die angelegte Spannung, die Dauer der Oxidation, der gewählte Elektrolyt und schließlich die Zusammensetzung der Verschleißerkennungsschicht sind die maßgeblichen Parameter, welche die Eindringtiefe der anodischen Oxidation von der äußeren Oberfläche der Verschleißerkennungsschicht in Richtung des Substrats bestimmen. Je nach Eindringtiefe werden unterschiedliche Farbeffekte erzielt. Die Parameter der anodischen Oxidation werden so gewählt, dass die Oxidation bis zu einer Eindringtiefe erfolgt, welche sich nicht über die gesamte Dicke der Verschleißerkennungsschicht erstreckt, da angenommen wird, dass der Farbeffekt der erfindungsgemäßen Verschleißerkennungsschicht auf der Reflexion von Licht an dem nicht oxidierten inneren Bereich der Verschleißerkennungsschicht beruht. Es ist daher vorteilhaft, einen solchen nicht oxidierten Bereich der Verschleißerkennungsschicht durch Einstellen der Eindringtiefe der anodischen Oxidation zu erhalten.

Die innerhalb einer Einzellage, welche wenigstens zwei verschiedene Metalle enthält, vor der anodischen Oxidation und in den nicht anodisch oxidierten Bereichen vorhandenen Phasen lassen sich mittels Röntgenbeugungsanalyse und/oder TEM identifizieren. In den Bereichen der Verschleißerkennungsschicht, welche anodischer Oxidation unterzogen wurden, sind unterschiedliche Phasen nicht mehr im Röntgenbeugungssprektrum oder TEM nachweisbar. Die Verfahren der Röntgenbeugungsanalyse und der TEM sind dem Fachmann auf dem Gebiet bekannt und erfordern keine weitere Erläuterung. Die Unterscheidung der verschiedenen Phasen in einem Röntgenbeugungssprektrum kann durch Vergleich der Peakpositionen mit denjenigen entsprechender bekannter Referenzen erfolgen. Beispielsweise werden Phasen der Einzelmetalle durch Vergleich mit den Referenzspektren der Reinmetalle und intermetallische Phasen durch Vergleich mit den Referenzspektren der entsprechenden Legierungen identifiziert. Die Unterscheidung der verschiedenen Phasen mittels TEM erfolgt mittels Elektronenbeugung.

Die Einzellage einer einlagigen Verschleißerkennungsschicht (A) kann eine Dicke von 250 nm bis 5 µm, vorzugsweise von 400 nm bis 2 µm, besonders bevorzugt von 500 nm bis 1,2 µm aufweisen. Ist die Einzellage der einlagigen Verschleißerkennungsschicht (A) zu dünn, besteht die Gefahr, dass die anodische Oxidation über die gesamte Dicke der Verschleißerkennungsschicht bis in die darunter liegende Verschleißschutzbeschichtung oder bis in das Substrat erfolgt und die Verschleißschutzbeschichtung oder das Substrat von dem üblicherweise sauren Elektrolyten der anodischen Oxidation angegriffen wird. Ist die Einzellage der Verschleißerkennungsschicht mit Monolayer-Struktur zu dick, wirkt sich dies ungünstig auf die tribologischen Eigenschaften der Beschichtung und damit ungünstig auf den Zerspanprozess und das Verschleißverhalten der Werkzeuge aus. Darüber hinaus besteht bei einer zu dicken Einzellage die Gefahr; dass sich die Lage beim Zerspanprozess leicht vom Substrat oder der Verschleißschutzbeschichtung ablöst.

In einer bevorzugten Ausführungsform der Erfindung umfasst die mehrlagige Verschleißerkennungsschicht (B) 4 bis 2000, vorzugsweise 20 bis 500, besonders bevorzugt 50 bis 100 übereinander angeordnete Einzellagen. Die Einzellagen sind sehr dünn, vorzugsweise weisen sie eine Dicke von 10 nm bis 250 nm, besonders bevorzugt von 10 nm bis 100 nm auf. Bei einer zu niedrigen Anzahl von Einzellagen besteht aufgrund der geringen Dicke der Einzellagen die Gefahr, dass die anodische Oxidation über die gesamte Dicke der Verschleißerkennungsschicht bis in die darunter liegende Verschleißschutzbeschichtung oder bis in das Substrat erfolgt und die Verschleißschutzbeschichtung oder das Substrat von dem üblicherweise sauren Elektrolyten der anodischen Oxidation angegriffen wird. Ist die Anzahl der Einzellagen zu hoch, ist die Gesamtdicke der Verschleißerkennungsschicht sehr groß, was sich ungünstig auf die tribologischen Eigenschaften der Beschichtung und damit ungünstig auf den Zerspanprozess und das Verschleißverhalten der Werkzeuge auswirken kann. Darüber hinaus besteht bei einer zu dicken Verschleißerkennungsschicht die Gefahr; dass sich die Schicht beim Zerspanprozess leicht vom Substrat oder der Verschleißschutzbeschichtung ablöst.

In einer weiteren bevorzugten Ausführungsform der Erfindung sind die in der mehrlagigen Verschleißerkennungsschicht (B) enthaltenen Metalle unter Nb, Ti, Zr, Al, Ta, W, Hf, V, Mo und Si ausgewählt. Werden elektrisch leitfähige Metallverbindungen im PVD-Verfahren abgeschieden, sind diese bevorzugt unter Nitriden, Carbiden und Boriden der vorgenannten Metalle, soweit diese elektrisch leitfähig sind, ausgewählt.

Ganz besonders bevorzugt sind die in der wenigstens zwei verschiedene Metalle enthaltenden Einzellage der mehrlagigen Verschleißerkennungsschicht (B) enthaltenen Metalle Ti und Si. Diese Kombination der Metalle Ti und Si liefert brilliante Farben und ermöglicht die Herstellung einer Vielzahl verschiedener Farben des sichtbaren Spektrums. Im Röntgenbeugungsspektrum einer Einzellage, welche nur die Metalle Ti und Si enthält, wurden wenigstens drei Phasen identifiziert, eine metallische Ti-Phase, eine metallische Si-Phase und wenigstens eine intermetallische TiSi-Phase, wobei der anhand des Röntgenbeugungsspektrums abgeschätzte Anteil der metallischen Ti- und Si-Phasen im Verhältnis zu der wenigstens einen intermetallischen TiSi-Phase hoch ist.

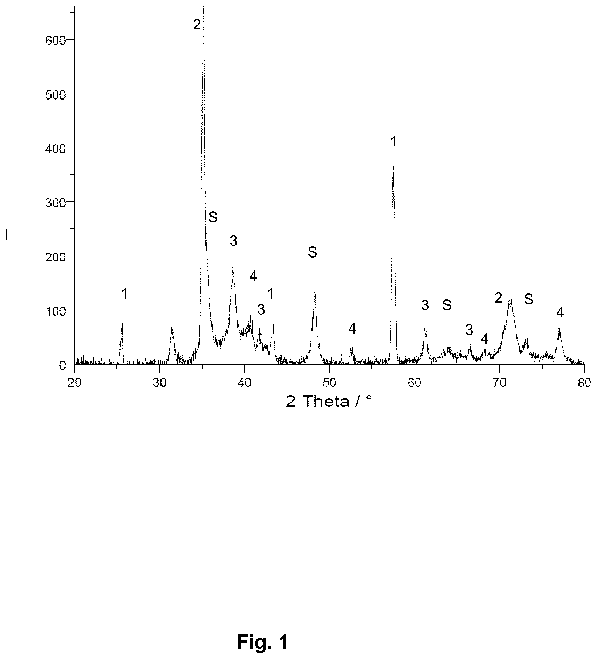

Ein Röntgenbeugungsspektrum einer Einzellage, welche nur die Metalle Ti und Si enthält, ist in Figur 1 gezeigt. Die Einzellage wurde im Lichtbogenverfahren (Arc-PVD) von einem Ti und Si im Atom-%-Verhältnis 85:15 enthaltenden Mischtarget in einer Lagendicke von 0,8 µm bei einem Verdampferstrom von 160 A, einem Ar-Druck von 2 Pa und einem Bias von 10 V abgeschieden.

In einer weiteren bevorzugten Ausführungsform der Erfindung sind die in der wenigstens zwei verschiedene Metalle enthaltenden Einzellage der mehrlagigen Verschleißerkennungsschicht (B) enthaltenen Metalle im PVD-Verfahren von gemischtmetallischen Targets, welche sämtliche der in der Einzellage vorhandenen Metalle enthalten, abgeschieden.

In einer weiteren bevorzugten Ausführungsform weist die mehrlagige Verschleißerkennungsschicht (B) eine Gesamtschichtdicke von 2 nm bis 20 µm, vorzugsweise von 10 nm bis 5 µm, besonders bevorzugt von 100 nm bis 1 µm auf. Bei einer zu geringen Gesamtschichtdicke besteht die Gefahr, dass die anodische Oxidation über die gesamte Dicke der Verschleißerkennungsschicht bis in die darunter liegende Verschleißschutzbeschichtung oder bis in das Substrat erfolgt und die Verschleißschutzbeschichtung oder das Substrat von dem üblicherweise sauren Elektrolyten der anodischen Oxidation angegriffen wird. Ist die Gesamtschichtdicke der Verschleißerkennungsschicht zu groß, kann sich dies ungünstig auf die tribologischen Eigenschaften der Beschichtung und damit ungünstig auf den Zerspanprozess und das Verschleißverhalten der Werkzeuge auswirken. Darüber hinaus besteht bei einer zu dicken Verschleißerkennungsschicht die Gefahr; dass sich die Schicht beim Zerspanprozess leicht vom Substrat oder der Verschleißschutzbeschichtung ablöst.

In einer besonders bevorzugten Ausführungsform der Erfindung ist auf dem Substratkörper unter der Verschleißerkennungsschicht eine mehrlagige Verschleißschutzbeschichtung angeordnet, welche vorzugsweise wenigstens eine elektrisch nicht leitfähige Schicht umfasst und besonders bevorzugt eine Aluminiumoxidschicht umfasst.

Das Aufbringen der erfindungsgemäßen Verschleißerkennungsschicht über einer nichtleitfähigen Verschleißschutzschicht, ganz besonders bevorzugt über einer AluminiumoxidSchicht, die aufgrund ihrer Härte und Verschleißbeständigkeit bei sehr vielen Werkzeugen für die spanende Metallbearbeitung mit Vorteil als Verschleißschutzschicht, alleine oder in Kombination mit weiteren Hartstofflagen, eingesetzt wird, hat den besonderen Vorteil, dass es beim Verfahren der anodischen Oxidation der Verschleißerkennungsschicht aufgrund der darunter angeordneten nicht-leitenden Schicht nicht zu sogenannten Durchschlägen beim Anodisierprozess kommen kann. Die Verschleißerkennungsschicht kann dann sehr dünn ausgebildet sein.

In der Erfindung sind die PVD-Verfahren für das Aufbringen der Einzellagen der Verschleißerkennungsschicht aus Metall, Metalllegierung oder elektrisch leitfähiger Metallverbindung unter Lichtbogenverdampfen, HIPIMS und dualem Magnetronsputtern ausgewählt. Für das Abscheiden der mehrlagigen Verschleißerkennungsschicht werden verschieden zusammengesetzte Targets entsprechend den unterschiedlichen Lagenzusammensetzungen eingesetzt. Dabei kann die Abscheidung von den verschiedenen Targets durch das gleiche PVD-Verfahren erfolgen. Es können für die verschiedenen Targets aber auch unterschiedliche PVD-Verfahren angewendet werden. Eine mehrlagige Verschleißerkennungsschicht mit abwechselnd unterschiedlichen Lagenzusammensetzungen, insbesondere wenn sehr dünne Lagen hergestellt werden sollen, kann in einem PVD-Prozess abgeschieden werden, bei dem die verschiedenen Targets auf verschiedenen Positionen im Reaktor verteilt sind und die zu beschichtende Seite des Werkzeugkörpers wiederholt nacheinander an den verschiedenen Targets vorbeigeführt wird, beispielsweise durch Mehrfachrotation auf einem Drehteller o. ä.

In einer weiteren bevorzugten Ausführungsform der Erfindung wurde die Verschleißerkennungsschicht von ausgewählten Bereichen des Werkzeugs wieder entfernt, vorzugsweise durch abrasives Strahlverfahren mit einem partikulären Strahlmittel, durch Schleifen oder durch Bürsten. Es kann erwünscht sein, dass bestimmte Bereiche des Werkzeugs die Oberfläche des Substratkörpers oder der Verschleißschutzbeschichtung als äußerste Oberfläche aufweisen, beispielsweise an der Schneidkante und auf der Spanfläche, wenn eine Verschleißerkennungsschicht in diesen Bereichen dem Werkzeug für die jeweilige vorgesehene Anwendung ungünstige Eigenschaften verleihen könnte oder einfach um dem Werkzeug einen gewünschten optischen Charakter zu verleihen. Des weiteren können die abrasiven Verfahren zum Entfernen der Verschleißerkennungsschicht, wie beispielsweise Strahlverfahren oder Bürsten, eingesetzt werden, um die Oberflächenrauheit der entsprechenden Bereiche zu glätten oder die Eigenspannungsverhältnisse in der Verschleißschutzbeschichtung und ggf. auch der Äußeren Substratbereiche zu beeinflussen. Bekanntermaßen lassen sich durch Strahlverfahren mit partikulären Strahlmitteln Zugspannungen in Hartstofflagen abbauen und/oder Druckspannungen einbringen, womit sich beispielsweise die Haft- und Verschleißeigenschaften der Lagen verbessern lassen.

Die anodische Oxidation der Verschleißerkennungsschicht erfolgt in einem Elektrolytbad bei einer Gleichspannung und für einen Zeitraum, welche so ausgewählt sind, dass die anodische Oxidation von der äußeren Oberfläche der Verschleißerkennungsschicht bis zu einer Eindringtiefe erfolgt, die geringer ist als die Gesamtdicke der Verschleißerkennungsschicht. Ein Beispiel für ein geeignetes Elektrolytbad ist eine wässrige Lösung mit 25-50 % Phosphorsäure und 1-5 % Oxalsäure.

Die Erfindung umfasst auch ein Verfahren zur Herstellung eines Werkzeugs der hierin zuvor beschriebenen erfindungsgemäßen Art, bei dem man auf ein Werkzeug aus einem Substratkörper aus Hartmetall, Cermet, Keramik, Stahl oder Schnellarbeitsstahl, welches optional eine auf dem Substratkörper abgeschiedene ein- oder mehrlagige Verschleißschutzbeschichtung aufweist, mittels PVD-Verfahren eine Verschleißerkennungsschicht der hierin beschriebenen erfindungsgemäßen Art aufbringt und anschließend die Verschleißerkennungsschicht einer anodischen Oxidation in einem Elektrolytbad unterzieht. Die anodische Oxidation wird zweckmäßigerweise bei einer Gleichspannung und für einen Zeitraum durchgeführt wird, welche so ausgewählt sind, dass die anodische Oxidation von der äußeren Oberfläche der Verschleißerkennungsschicht bis zu einer Eindringtiefe erfolgt, die geringer ist als die Gesamtdicke der Verschleißerkennungsschicht. Das Verfahren ist einfach und kostengünstig und bietet die Möglichkeit viele unterschiedliche Farbgebungen herzustellen.

Für Zwecke der ursprünglichen Offenbarung wird darauf hingewiesen, dass sämtliche Merkmale wie sie sich aus der vorliegenden Beschreibung und den abhängigen Ansprüchen für einen Fachmann erschließen, auch wenn sie konkret nur im Zusammenhang mit bestimmten weiteren Merkmale beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gründe derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

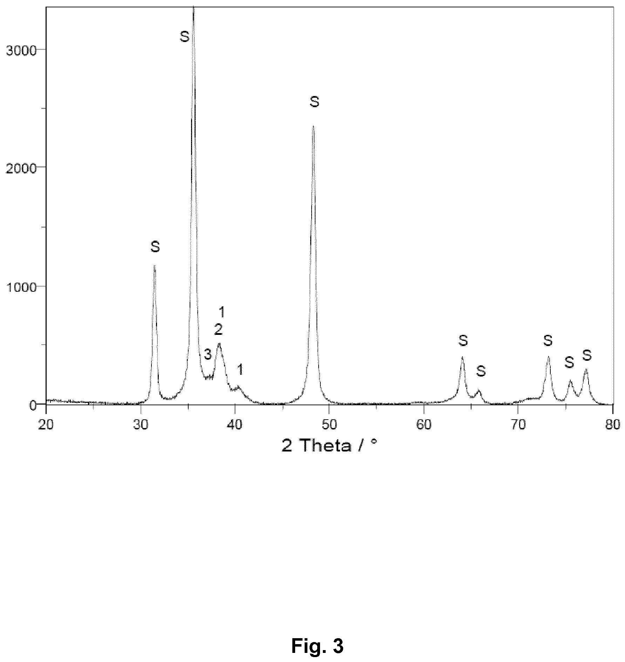

Weitere Vorteile, Merkmale und Anwendungsmöglichkeiten der vorliegenden Erfindung werden anhand Beispiel 3 und Figur 3 weiter erläutert.

### Figuren

- Figur 1: zeigt das Röntgenbeugungsspektrum einer die Metalle Ti und Si enthaltenden Verschleißerkennungsschicht gemäß Beispiel 1 vor der anodischen Oxidation.
- Figur 2: zeigt das Röntgenbeugungsspektrum einer die Metalle Ti und Al enthaltenden Verschleißerkennungsschicht gemäß Beispiel 2 vor der anodischen Oxidation.
- Figur 3: zeigt das Röntgenbeugungsspektrum einer die Metalle Ti und Al enthaltenden Verschleißerkennungsschicht gemäß Beispiel 3 vor der anodischen Oxidation.
- Figur 4: zeigt das Röntgenbeugungsspektrum einer das Metall Ti enthaltenden Verschleißerkennungsschicht gemäß Vergleichsbeispiel 1 vor der anodischen Oxidation.
- Figur 5: zeigt das Röntgenbeugungsspektrum einer das Metall Zr Verschleißerkennungsschicht gemäß Vergleichsbeispiel 2 vor der anodischen Oxidation.

### Beispiele

Für die nachfolgenden Beispiele wurden Hartmetallsubstrate, die eine Verschleißschutzbeschichtung mit einer äußersten Lage aus Al₂O₃ aufwiesen, in einer PVD-Beschichtungsanlage (Flexicoat; Hauzer Techno Coating) mittels Lichtbogenverdampfen (Arc-PVD) mit einer ein- oder mehrlagigen Verschleißerkennungsschicht versehen. Die Abscheidungsparameter sind in den jeweiligen Beispielen angegeben.

Anschließend wurden die beschichteten Hartmetallsubstrate anodischer Oxidation in einem wässrigen Elektrolytbad für eine Anodisierzeit t_{anod} bei unterschiedlichen Spannungen U_{anod} unterzogen. Die Dicke des durch die anodische Oxidation entstehenden Oxids war im Wesentlichen proportional zur angelegten Spannung.

Die Peaks der in den Figuren gezeigten Röntgenbeugungsspektren der gemäß den Beispielen hergestellten Lagen wurden mit den Peakpositionen der bekannten Referenzspektren (PDF-Karten) verglichen, um die in einer Lage enthaltenen Phasen zu identifizieren. In den Figuren sind die einer Phase zugeordneten Peaks daher mit jeweils der gleichen Zahl (z. B. 1, 2, 3 oder 4) markiert. Peaks, die vom Substratkörper herrühren, sind mit dem Buchstaben "S" markiert. In den Legenden zu den Figuren sind die Nummern der jeweils verwendeten PDF-Karten angegeben.

### Beispiel 1: Herstellung einer einlagigen Verschleißerkennunasschicht

| | |
|---|---|
| Target | Titan-Silizium-Mischtarget (Ti:Si = 85:15 Atom-%) |
| Abscheidungsparameter | 160 A Verdampferstrom, 2 Pa Argon, Bias 10 V |
| Schicht | Einzellage; 0,8 µm Dicke |
| anodische Oxidation | t_{anod} = 30 Sek; U_{anod} = 35 V, 85 V, 120 V; Elektrolytbad: 35% Phosphorsäure, 5% Oxalsäure, Rest Wasser |

Es wurden folgende Farben der Verschleißerkennungsschicht erhalten:

| U_{anod} | Farbe |
|---|---|
| 35 V | blau |
| 85 V | lila-violett |
| 120 V | hellgrün |

Die im PVD-Verfahren abgeschiedene Verschleißerkennungsschicht wurde vor der anodischen Oxidation einer Röntgenbeugungsanalyse unterzogen. Das Röntgenbeugungsspektrum ist in Figur 1 wiedergegeben. Der Vergleich der erhaltenen Peaks mit den Referenzspektren von reinem Titan, reinem Silizium und Titan-Silizium-Legierung zeigt, dass die abgeschiedene Einzellage wenigstens drei verschiedene metallische Phasen aufweist, eine metallische Titan-Phase, eine metallische Silizium-Phase und eine intermetallische Titan-Silizium-Phase. Ein weiterer, nicht identifizierter Peak bei etwa 53 ° 2-Theta zeigt eine weitere wahrscheinlich intermetallische Phase, jedoch wurde dieser Peak in den bekannten Referenzspektren nicht aufgefunden, was darauf zurückgeführt wird, dass diese Phase noch nicht als Referenz erfasst bzw. veröffentlicht wurde.

### Beispiel 2: Herstellung einer einlagigen Verschleißerkennunasschicht

| | |
|---|---|
| Target | Titan-Aluminium-Mischtarget (Ti:Al = 50:50 Atom-%) |
| Abscheidungsparameter | 160 A Verdampferstrom, 1,5 Pa Argon, Bias 20 V |
| Schicht | Einzellage; 1,0 µm Dicke |
| anodische Oxidation | t_{anod} = 30 Sek; U_{anod} = 50 V, 80 V; Elektrolytbad: Zitronensäure (1 mol/l) in Wasser gelöst |

Es wurden folgende Farben der Verschleißerkennungsschicht erhalten:

| U_{anod} | Farbe |
|---|---|
| 50 V: | grün |
| 80 V: | gelb |

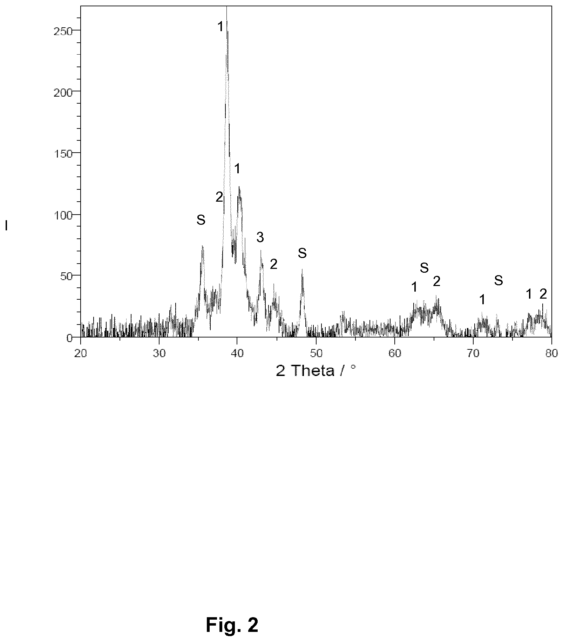

Die im PVD-Verfahren abgeschiedene Verschleißerkennungsschicht wurde vor der anodischen Oxidation einer Röntgenbeugungsanalyse unterzogen. Das Röntgenbeugungsspektrum ist in Figur 2 wiedergegeben. Der Vergleich der erhaltenen Peaks mit den Referenzspektren von reinem Titan, reinem Aluminium und Titan-Aluminium-Legierung zeigt, dass die abgeschiedene Einzellage wenigstens zwei verschiedene metallische Phasen aufweist, eine metallische Titan-Phase und eine metallische Aluminium-Phase. Ein weiterer, nicht identifizierter Peak bei etwa 43 ° 2-Theta zeigt eine weitere wahrscheinlich intermetallische Titan-Aluminium-Phase, jedoch wurde dieser Peak in den bekannten Referenzspektren nicht aufgefunden, was darauf zurückgeführt wird, dass diese Phase noch nicht als Referenz erfasst bzw. veröffentlicht wurde.

### Beispiel 3: Herstellung einer erfindungsgemäßen mehrlagigen Verschleißerkennungsschicht

| | |
|---|---|
| Target 1 | Titan |
| Target 2 | Titan-Aluminium-Mischtarget (Ti:Al = 50:50 Atom-%) |
| Abscheidungsparameter | 160 A Verdampferstrom, 1,0 Pa Argon, 50 sccm N₂, Bias 60 V |
| Schicht | 40 Lagen (20 Ti-Lagen, 20 Ti-Al-Lagen); jeweils 18 nm Dicke; Gesamtschichtdicke: 0,72 µm |
| anodische Oxidation | t_{anod} = 30 Sek; U_{anod} = 80 V, 150 V; Elektrolytbad: Zitronensäure (1 mol/l) in Wasser gelöst |

Es wurden folgende Farben der Verschleißerkennungsschicht erhalten:

| U_{anod} | Farbe |
|---|---|
| 80 V: | rot-gold |
| 150 V: | blau-grün |

Die im PVD-Verfahren abgeschiedene Verschleißschutzbeschichtung wurde vor der anodischen Oxidation einer Röntgenbeugungsanalyse unterzogen. Das Röntgenbeugungsspektrum ist in Figur 3 wiedergegeben. Der Vergleich der erhaltenen Peaks mit den Referenzspektren von reinem Titan, reinem Aluminium und Titan-Aluminium-Legierung zeigt, dass die abgeschiedene Einzellage wenigstens zwei verschiedene metallische Phasen aufweist, eine metallische Titan-Phase und eine metallische Aluminium-Phase. Ein weiterer, nicht identifizierter Peak bei etwa 37 ° 2-Theta zeigt eine weitere wahrscheinlich intermetallische Titan-Aluminium-Phase, jedoch wurde dieser Peak in den bekannten Referenzspektren nicht aufgefunden, was darauf zurückgeführt wird, dass diese Phase noch nicht als Referenz erfasst bzw. veröffentlicht wurde.

Durch Elektronenbeugung (TEM) konnte nachgewiesen werden, dass innerhalb wenigstens einer Einzellage der mehrlagigen Schicht wenigstens zwei verschiedene Phasen der in der Röntgenbeugungsanalyse aufgefundenen Phasen vorhanden sind. Da bereits in der Röntgenbeugungsanalyse drei Phasen beobachtet wurden und nur zwei verschiedene Lagenzusammensetzungen alternierend übereinander abgeschieden wurden, zeigt bereits die Röntgenbeugungsanalyse, dass in einer der Einzellagen wenigstens zwei verschiedene Phasen vorhanden sind.

### Vergleichsbeispiel 1: Herstellung einer einlagigen Verschleißerkennunasschicht

| | |
|---|---|
| Target | Titan (160 mm Durchmesser) |
| Abscheidungsparameter | 160 A Verdampferstrom, 1,0 Pa Argon, Bias 10 V |
| Schicht | Einzellage; 1,0 µm Dicke |
| anodische Oxidation | t_{anod} = 30 Sek; U_{anod} = 20 V, 40 V; Elektrolytbad: Zitronensäure (1 mol/l) in Wasser gelöst |

Es wurden folgende Farben der Verschleißerkennungsschicht erhalten:

| U_{anod} | Farbe |
|---|---|
| 20 V: | lila |
| 40 V: | blau |

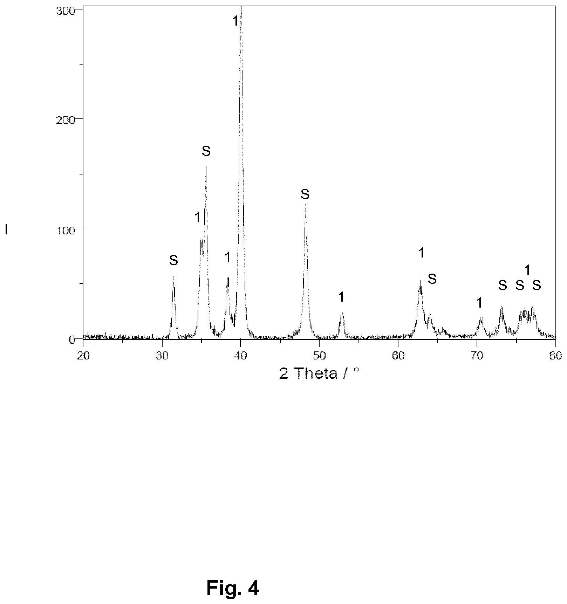

Die im PVD-Verfahren abgeschiedene Verschleißerkennungsschicht wurde vor der anodischen Oxidation einer Röntgenbeugungsanalyse unterzogen. Das Röntgenbeugungsspektrum ist in Figur 4 wiedergegeben. Der Vergleich der erhaltenen Peaks mit dem Referenzspektrum von reinem Titan zeigt, dass die abgeschiedene Einzellage aus einer einzigen metallischen Ti-Phase besteht.

### Vergleichsbeispiel 2: Herstellung einer einlagigen Verschleißerkennunasschicht

| | |
|---|---|
| Target | Zirkonium (160 mm Durchmesser) |
| Abscheidungsparameter | 160 A Verdampferstrom, 2,0 Pa Argon, Bias 30 V |
| Schicht | Einzellage; 0,5 µm Dicke |
| anodische Oxidation | t_{anod} = 30 Sek; U_{anod} = 50 V, 85 V; Elektrolytbad: Zitronensäure (1 mol/l) in Wasser gelöst |

Es wurden folgende Farben der Verschleißerkennungsschicht erhalten:

| U_{anod} | Farbe |
|---|---|
| 50 V: | hellblau |
| 85 V: | gelb |

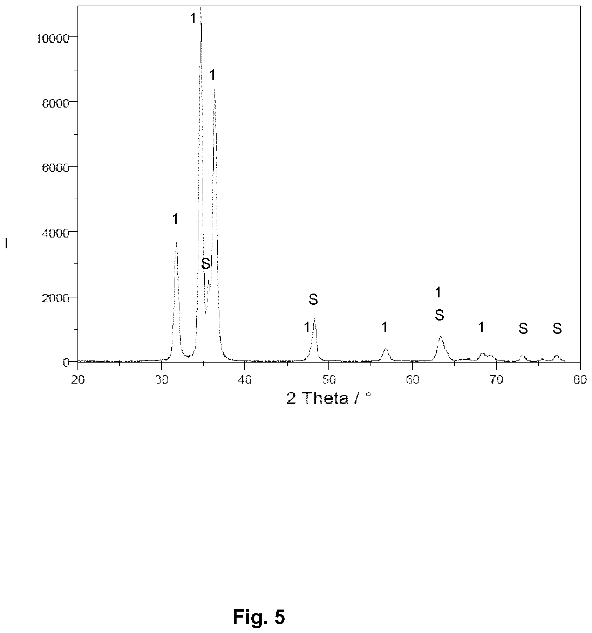

Die im PVD-Verfahren abgeschiedene Verschleißerkennungsschicht wurde vor der anodischen Oxidation einer Röntgenbeugungsanalyse unterzogen. Das Röntgenbeugungsspektrum ist in Figur 5 wiedergegeben. Der Vergleich der erhaltenen Peaks mit dem Referenzspektrum von nem Zirkonium zeigt, dass die abgeschiedene Einzellage aus einer einzigen metallischen Zr-Phase besteht.

Die Verschleißerkennungsschichten gemäß den Beispielen 1 bis 3 zeigten gegenüber den Schichten der Vergleichsbeispiele eine deutlich bessere Kratzbeständigkeit und Abriebfestigkeit sowie eine visuell beurteilte höhere Farbbrillianz.

### Bezugszeichen / Legenden

**Bezugszeichen / Legende zu Figur 1:**

| | |
|---|---|
| S | Substrat PDF 25-1047 |
| 1 | Si PDF 40-932 |
| 2 | Ti PDF 5-682 |
| 3 | TiSi PDF 27-907 |
| 4 | nicht identifiziert |
| I | Intensität (willkürliche Einheiten) |

**Bezuaszeichen / Legende zu Figur 2:**

| | |
|---|---|
| S | Substrat PDF 25-1047 |
| 1 | Ti PDF 5-682 |
| 2 | Al PDF 4-787 |
| 3 | nicht identifizierte TiAl-Phase |
| I | Intensität (willkürliche Einheiten) |

**Bezugszeichen / Legende zu Figur 3:**

| | |
|---|---|
| S | Substrat PDF 25-1047 |
| 1 | Ti PDF 5-682 |
| 2 | Al PDF 4-787 |
| 3 | nicht identifizierte TiAl-Phase |
| I | Intensität (willkürliche Einheiten) |

**Bezugszeichen / Legende zu Figur 4:**

| | |
|---|---|
| S | Substrat PDF 25-1047 |
| 1 | Ti PDF 5-682 |
| I | Intensität (willkürliche Einheiten) |

**Bezugszeichen / Legende zu Figur 5:**

| | |
|---|---|
| S | Substrat PDF 25-1047 |
| 1 | Zr PDF 5-665 |
| I | Intensität (willkürliche Einheiten) |

## Patentansprüche

1. Werkzeug, bestehend aus
- einem Substratkörper aus Hartmetall, Cermet, Keramik, Stahl oder Schnellarbeitsstahl,
- einer optional auf dem Substratkörper abgeschiedenen ein- oder mehrlagigen Verschleißschutzbeschichtung und
- einer als äußerste Schicht über dem Substratkörper oder der optionalen Verschleißschutzbeschichtung angeordneten, wenigstens 4 übereinander angeordnete Einzellagen umfassenden mehrlagigen Verschleißerkennungsschicht (B), hergestellt durch Abscheidung von elementaren Metallen, Metalllegierungen oder elektrisch leitfähigen Metallverbindungen im PVD-Verfahren,
**dadurch gekennzeichnet, dass**
wenigstens eine Einzellage der mehrlagigen Verschleißerkennungsschicht (B) wenigstens zwei verschiedene Metalle enthält,
die Verschleißerkennungsschicht einen durch anodische Oxidation des Materials der Verschleißerkennungsschicht von der äußeren Oberfläche der Verschleißerkennungsschicht bis zu einer Eindringtiefe, welche sich nicht über die gesamte Dicke der Verschleißerkennungsschicht erstreckt, hergestellten Bereich umfasst,
jede Einzellage der mehrlagigen Verschleißerkennungsschicht (B) eine Dicke im Bereich von 10 nm bis 1 µm aufweist und
die wenigstens eine wenigstens zwei verschiedene Metalle enthaltende Einzellage der mehrlagigen Verschleißerkennungsschicht (B) vor der anodischen Oxidation und in den nicht anodisch oxidierten Bereichen der Verschleißerkennungsschicht wenigstens zwei verschiedene Phasen aufweist.

2. Werkzeug nach Anspruch 1, **dadurch gekennzeichnet, dass** die Einzellagen der mehrlagigen Verschleißerkennungsschicht (B) jeweils eine Dicke von 10 nm bis 250 nm, vorzugsweise von 10 nm bis 100 nm aufweisen.

3. Werkzeug nach einem der vorangegangenen Ansprüche, **dadurch gekennzeichnet, dass** die in der mehrlagigen Verschleißerkennungsschicht (B) enthaltenen Metalle unter Nb, Ti, Zr, Al, Ta, W, Hf, V, Mo und Si ausgewählt sind.

4. Werkzeug nach einem der vorangegangenen Ansprüche, **dadurch gekennzeichnet, dass** die in der wenigstens zwei verschiedene Metalle enthaltenden Einzellage der mehrlagigen Verschleißerkennungsschicht (B) enthaltenen Metalle Ti und Si sind.

5. Werkzeug nach einem der vorangegangenen Ansprüche, **dadurch gekennzeichnet, dass** die in der wenigstens zwei verschiedene Metalle enthaltenden Einzellage der mehrlagigen Verschleißerkennungsschicht (B) enthaltenen Metalle im PVD-Verfahren von gemischtmetallischen Targets, welche sämtliche der in der Einzellage vorhandenen Metalle enthalten, abgeschieden sind.

6. Werkzeug nach einem der vorangegangenen Ansprüche, **dadurch gekennzeichnet, dass** die mehrlagige Verschleißerkennungsschicht (B) 4 bis 2000, vorzugsweise 20 bis 500, besonders bevorzugt 50 bis 100 übereinander angeordnete Einzellagen umfasst.

7. Werkzeug nach einem der vorangegangenen Ansprüche, **dadurch gekennzeichnet, dass** die mehrlagige Verschleißerkennungsschicht (B) eine Gesamtschichtdicke von 2 nm bis 20 µm, vorzugsweise von 10 nm bis 5 µm, besonders bevorzugt von 100 nm bis 1 µm aufweist.

8. Werkzeug nach einem der vorangegangenen Ansprüche, **dadurch gekennzeichnet, dass** die im PVD-Verfahren abgeschiedenen elektrisch leitfähigen Metallverbindungen unter Nitriden, Carbiden und Boriden der jeweiligen Metalle ausgewählt sind, soweit die Verbindungen elektrisch leitfähig sind.

9. Werkzeug nach einem der vorangegangenen Ansprüche, **dadurch gekennzeichnet, dass** auf dem Substratkörper unter der Verschleißerkennungsschicht eine ein- oder mehrlagige, vorzugsweise eine mehrlagige Verschleißschutzbeschichtung angeordnet ist, welche vorzugsweise wenigstens eine elektrisch nicht leitfähige Schicht umfasst, besonders bevorzugt eine Aluminiumoxidschicht.

10. Werkzeug nach einem der vorangegangenen Ansprüche, **dadurch gekennzeichnet, dass** die PVD-Verfahren für das Aufbringen der Einzellagen der Verschleißerkennungsschicht aus Metall, Metalllegierung oder elektrisch leitfähiger Metallverbindung unter Lichtbogenverdampfen, HIPIMS und dualem Magnetronsputtern ausgewählt sind.

11. Werkzeug nach einem der vorangegangenen Ansprüche, **dadurch gekennzeichnet, dass** die Verschleißerkennungsschicht von ausgewählten Bereichen des Werkzeugs wieder entfernt wurde, vorzugsweise durch abrasives Strahlverfahren mit einem partikulären Strahlmittel, durch Schleifen oder durch Bürsten.

12. Verfahren zur Herstellung eines Werkzeugs mit einer Verschleißerkennungsschicht nach einem der vorangegangenen Ansprüche, bei dem man auf ein Werkzeug aus einem Substratkörper aus Hartmetall, Cermet, Keramik, Stahl oder Schnellarbeitsstahl, welches optional eine auf dem Substratkörper abgeschiedene ein- oder mehrlagigen Verschleißschutzbeschichtung aufweist, eine Verschleißerkennungsschicht aus Metall, Metalllegierung oder elektrisch leitfähiger Metallverbindung im PVD-Verfahren aufbringt und anschließend die Verschleißerkennungsschicht einer anodischen Oxidation in einem Elektrolytbad unterzieht, wobei die anodische Oxidation bei einer Gleichspannung und für einen Zeitraum durchgeführt wird, welche so ausgewählt sind, dass die anodische Oxidation von der äußeren Oberfläche der Verschleißerkennungsschicht bis zu einer Eindringtiefe erfolgt, die geringer ist als die Gesamtdicke der Verschleißerkennungsschicht.

## Claims

1. Tool, consisting of
- a substrate body made of hard metal, cermet, ceramic, steel or high-speed steel,
- optionally a single-layer or multi-layer wear protection coating deposited on the substrate body and
- a multi-layer wear recognition layer (B) comprising at least four individual layers arranged one over another, produced by deposition of elemental metals, metal alloys or electrically conductive metal compounds by the PVD process, deposited as the outermost layer over the substrate body or the optional wear protection coating,
**characterised in that**
at least one individual layer of the multi-layer wear recognition coating (B) contains at least two different metals,
the wear recognition layer comprises a region produced by anodic oxidation of the material of the wear recognition layer from the outer surface of the wear recognition layer to a depth of penetration which does not extend to the total thickness of the wear recognition layer,
each individual layer of the multi-layer wear recognition layer (B) exhibits a thickness in the range of from 10 nm to 1 µm and
the at least one individual layer of the multi-layer wear recognition layer (B) containing at least two different metals exhibits at least two different phases prior to the anodic oxidation and in the regions of the wear recognition layer not oxidised anodically.

2. Tool according to claim 1, **characterised in that** the individual layers of the multi-layer wear recognition layer (B) each exhibit a thickness of from 10 nm to 250 nm, preferably of from 10 nm to 100 nm.

3. Tool according to one of the preceding claims, **characterised in that** the metals contained in the multi-layer wear recognition layer (B) are selected from Nb, Ti, Zr, Al, Ta, W, Hf, V, Mo and Si.

4. Tool according to one of the preceding claims, **characterised in that** the metals contained in the individual layer of the multi-layer wear recognition layer (B) containing at least two different metals are Ti and Si.

5. Tool according to one of the preceding claims, **characterised in that** the metals contained in the individual layer of the multi-layer wear recognition layer (B) containing at least two different metals are deposited by the PVD process from mixed metal targets which contain all the metals present in the individual layer.

6. Tool according to one of the preceding claims, **characterised in that** the multi-layer wear recognition layer (B) comprises 4 to 2000, preferably 20 to 500, particularly preferably 50 to 100 individual layers arranged over one another.

7. Tool according to one of the preceding claims, **characterised in that** the multi-layer wear recognition layer (B) exhibits a total layer thickness of from 2 nm to 20 µm, preferably of from 10 nm to 5 µm, particularly preferably of from 100 nm to 1 µm.

8. Tool according to one of the preceding claims, **characterised in that** the electrically conductive metal compounds deposited during the PVD process are selected from nitrides, carbides and borides of the respective metals, provided the compounds are electrically conductive.

9. Tool according to one of the preceding claims, **characterised in that** a single-layer or multi-layer wear protection coating, preferably a multi-layer wear protection coating, which preferably comprises at least one electrically non-conductive layer, particularly preferably an aluminium oxide layer, is arranged on the substrate body under the wear recognition layer.

10. Tool according to one of the preceding claims, **characterised in that** the PVD processes for the application of the individual layers of the wear recognition layer from metal, metal alloy or electrically conductive metal compound are selected from arc evaporation, HIPIMS and dual magnetron sputtering.

11. Tool according to one of the preceding claims, **characterised in that** the wear recognition layer is removed again from selected regions of the tool, preferably by an abrasive blasting process with a particulate blasting medium, by grinding or by brushing.

12. Method for the production of a tool with a wear recognition layer according to one of the preceding claims, in which a wear recognition layer is applied from metal, metal alloy or electrically conductive metal compound by the PVD process to a tool consisting of a substrate body made of hard metal, cermet, ceramic, steel or high-speed steel, which optionally exhibits a single-layer or multi-layer wear protection coating deposited on the substrate body, and then the wear recognition layer is subjected to anodic oxidation in an electrolyte bath, wherein the anodic oxidation is carried out at a DC voltage and for a time which are selected so that the anodic oxidation is effected from the outer surface of the wear recognition layer to a depth of penetration which is less than the total thickness of the wear recognition layer.

## Revendications

1. Outil, consistant en
- un corps de substrat en métal dur, cermet, céramique, acier ou acier rapide,
- un revêtement anti-usure mono- ou multicouche déposé, en option, sur le corps de substrat, et
- une couche témoin d'usure multicouche (B) disposée en tant que couche la plus externe sur le corps de substrat ou le revêtement anti-usure optionnel et comprenant au moins 4 couches individuelles disposées les unes au-dessus des autres, réalisées par dépôt de métaux élémentaires, alliages métalliques ou composés métalliques électriquement conducteurs selon le procédé PVD,
**caractérisé**
**en ce qu'**au moins une couche individuelle de la couche témoin d'usure multicouche (B) contient au moins deux métaux différents,
**en ce que** la couche témoin d'usure comprend une zone réalisée par oxydation anodique du matériau de la couche témoin d'usure, de la surface extérieure de la couche témoin d'usure jusqu'à une profondeur de pénétration qui ne s'étend pas sur toute l'épaisseur de la couche témoin d'usure,
**en ce que** chaque couche individuelle de la couche témoin d'usure multicouche (B) présente une épaisseur située dans la plage de 10 nm à 1 µm, et
**en ce que** la au moins une couche individuelle de la couche témoin d'usure multicouche (B) contenant au moins deux métaux différents présente, avant l'oxydation anodique et dans les zones non oxydées anodiquement de la couche témoin d'usure, au moins deux phases différentes.

2. Outil selon la revendication 1, **caractérisé en ce que** les couches individuelles de la couche témoin d'usure multicouche (B) présentent respectivement une épaisseur de 10 nm à 250 nm, de préférence de 10 nm à 100 nm.

3. Outil selon l'une des revendications précédentes, **caractérisé en ce que** les métaux contenus dans la couche témoin d'usure multicouche (B) sont choisis parmi le Nb, Ti, Zr, Al, Ta, W, Hf, V, Mo et Si.

4. Outil selon l'une des revendications précédentes, **caractérisé en ce que** les métaux contenus dans la couche individuelle de la couche témoin d'usure multicouche (B) contenant au moins deux métaux différents sont le Ti et le Si.

5. Outil selon l'une des revendications précédentes, **caractérisé en ce que** les métaux contenus dans la couche individuelle de la couche témoin d'usure multicouche (B) contenant au moins deux métaux différents sont déposés, selon le procédé PVD, de cibles métalliques mixtes qui contiennent tous les métaux présents dans la couche individuelle.

6. Outil selon l'une des revendications précédentes, **caractérisé en ce que** la couche témoin d'usure multicouche (B) comprend de 4 à 2000, de préférence de 20 à 500, de manière particulièrement préférée de 50 à 100 couches individuelles disposées les unes au-dessus des autres.

7. Outil selon l'une des revendications précédentes, **caractérisé en ce que** la couche témoin d'usure multicouche (B) présente une épaisseur de couche totale de 2 nm à 20 µm, de préférence de 10 nm à 5 µm, de manière particulièrement préférée de 100 nm à 1 µm.

8. Outil selon l'une des revendications précédentes, **caractérisé en ce que** les composés métalliques électriquement conducteurs déposés selon le procédé PVD sont choisis parmi les nitrures, carbures ou borures des métaux respectifs, dans la mesure où les composés sont électriquement conducteurs.

9. Outil selon l'une des revendications précédentes, **caractérisé en ce qu'**est disposé sur le corps de substrat, sous la couche témoin d'usure, un revêtement anti-usure mono- ou multicouche, de préférence multicouche, qui comprend, de préférence, au moins une couche non conductrice électriquement, de manière particulièrement préférée une couche d'oxyde d'aluminium.

10. Outil selon l'une des revendications précédentes, **caractérisé en ce que** les procédés PVD destinés à l'application des couches individuelles de la couche témoin d'usure en métal, alliage métallique ou composé métallique électriquement conducteur sont choisis parmi l'évaporation par arc électrique, HIPIMS et la pulvérisation à double magnétron.

11. Outil selon l'une des revendications précédentes, **caractérisé en ce que** la couche témoin d'usure a été éliminée de régions sélectionnées de l'outil, de préférence par un procédé de grenaillage abrasif à l'aide d'un agent de grenaillage particulaire, par meulage ou par brossage.

12. Procédé de fabrication d'un outil doté d'une couche témoin d'usure selon l'une des revendications précédentes, dans lequel on applique sur un outil consistant en un corps de substrat en métal dur, cermet, céramique, acier ou acier rapide, qui présente, en option, un revêtement anti-usure mono- ou multicouche déposé sur le corps de substrat, une couche témoin d'usure en métal, alliage métallique ou composé métallique électriquement conducteur selon le procédé PVD, puis on soumet la couche témoin d'usure à une oxydation anodique dans un bain d'électrolyte, l'oxydation anodique étant réalisée à une tension continue et pour une durée choisie de telle sorte que l'oxydation anodique s'effectue de la surface extérieure de la couche témoin d'usure jusqu'à une profondeur de pénétration qui est inférieure à l'épaisseur totale de la couche témoin d'usure.
